# EUROPEAN PATENT APPLICATION

(11) **EP 1 959 568 A1**
(43) Date of publication of application: **20.08.2008**
(21) Application number: 07380041.9
(22) Date of filing: 19.02.2007
(51) Int. Cl.: H03H 9/17, H03H 9/05

(54) **Thin-film bulk acoustic ware resonator and method for performing heterogeneous integration of the same with complementary-metal-oxide-semiconductor integrated circuit**

(71) Applicant: Consejo Superior de Investigaciones Cientificas, 28006 Madrid (ES); Epson Europe Electronics GmbH, 80922 München (DE)
(72) Inventor: Campanella Pineda, Humberto Instituto de Microelectronica de Barcelona, E-08193 Bellaterra (Barcelona) (ES); Esteve Tintó, Jaume, Instituto de Microelectronica de Barcelona, E-08193 Bellaterra (Barcelona) (ES); Cabrujá Casas, Enric Instituto de Microelectronica de Barcelona, E-08193 Bellaterra (Barcelona) (ES); Montserrat Martí, José Instituto de Microelectronica de Barcelona, E-08193 Bellaterra (Barcelona) (ES); Terés Terés, Lluís Instituto de Microelectronica de Barcelona, E-08193 Bellaterra (Barcelona) (ES); Carmona Flores, Manuel, 80922 München (DE)
(74) Representative: Ungria Lopez, Javier

(57) **Abstract**

The present invention refers to a thin-film bulk acoustic wave resonator (FBAR) comprising:
- a first metal electrode;
- an acoustic layer;
- a second metal electrode;
- a carrier substrate;
- two or more supporting posts, said supporting posts connecting said first metal electrode and said second metal electrode to said carrier substrate;

said first metal electrode, said acoustic layer and said second metal electrode
arranged in a three-dimensional, floating structure, being said structure supported and interconnected to said carrier substrate by means of said supporting posts;
said first metal electrode interfacing in the vertical direction one of its surfaces withsaid acoustic layer and the second one with the air on top of said first metal electrode;
said acoustic layer interfacing in the vertical direction one of its surfaces with said first metal electrode and the second one with said second metal electrode;
said second metal electrode interfacing in the vertical direction one of its
surfaces with said acoustic layer and the second one with the air cavity formed in between said first metal electrode and said carrier substrate.

## Description

### TECHNICAL FIELD OF THE INVENTION

The present invention relates to acoustic resonators and its fabrication, to integrated circuits and its fabrication; and more particularly to the combination of the above techniques and methods for performing heterogeneous integration of thin-film bulk acoustic wave resonators (FBAR) with complementary-metal-oxide-semiconductor (CMOS) integrated circuit (IC).

### BACKGROUND OF THE INVENTION

The integration and process compatibility of micro-electromechanical systems (MEMS) to CMOS-integrated circuit technologies is one of the most demanding areas at both technology and application levels. Several issues like manufacturing temperature, packaging, and post-processing of MEMS; integrity of CMOS; and reliability and modeling of the MEMS-to-CMOS interface are just some examples that can be mentioned. The references presented in [1-3] describe some of the commented issues.

As a micro-machined resonant system, thin-film bulk acoustic wave resonators (FBAR) have also attracted the attention of RF integrated-circuit and sensor-application designers, being capable of achieving high performance in radio-frequency (RF) and sensor applications, as well. The first FBAR was presented by Lakin and Wang in 1981 [4] and, since then, RF filters and duplexers [5], mass and chemical sensors [6-8], and other acoustic-based sensors have been investigated and manufactured.

In considering the popularity and good response of FBAR, recent interest and latest developments in FBAR-to-CMOS integration have stimulated the conception of integrated applications in which FBAR is key component and whose IC integration is a requirement to proper functionality of the system. Different integration strategies have been investigated, being hybrid and monolithic integration the most relevant. By means of hybrid integration, two systems located in separated substrates are typically integrated by wire-bonding of the involved devices. In the case of FBAR-to-CMOS integration, the FBAR terminals are the bonding points of the first system to be connected, while the corresponding circuit nets do for the second system, in this case the IC. Examples of this integration approach are the oscillators presented in [9-11], where the FBAR performs thecrystal-like functionality in the system. Second approach for FBAR-to-CMOS is to monolithically integrate FBAR with CMOS circuitry. In the typical conception, FBAR is placed above the circuit, in order to save die area. This approach was disclosed in late 1993 [12], even a system integrating FBAR and radio circuitry was conceived in 2001 [13]. However, it was not as late as 2005 when the first monolithic FBAR-above-IC systems were demonstrated [14-16]. The interest for monolithic integration of FBAR has not limited to full-active ICs, but also for passive components like CMOS inductors [17]. Other MEMS, NEMS and SAW integrated resonators have been demonstrated, as well [18-20].

At the date, hybrid or monolithic approaches are main-stream integration strategies. Now, a third integration approach introduced by the present invention is wafer-level-transfer of FBAR into CMOS substrate or, vice versa, CMOS substrate may be transferred to FBAR substrate. For this purpose, this approach implements various techniques additional to standard CMOS and FBAR fabrication, including flip-chip, multi-chip-module, surface micromachining and packaging. Implemented in this invention, some of these techniques are utilized in a different way to the standard application. For example, packaging of MEMS or FBAR has traditionally been implemented as a protective means of device [21-24], where caps and protective structures are provided to enclose the device. Also, in [25], a method for packaging FBAR is presented, where a device chip having circuit elements and a cap is fabricated. To complete the process, the cap is placed on the device chip to connect a first contact point with a second contact point using the connector on the cap. On the other hand, a reduced substrate MEMS device and system for producing the same is disclosed in [26]. Here, a process in accordance with embodiments of the invention may include bonding a first packaging part to a MEMS device including a support substrate, removing the support substrate, and bonding a second packaging part to the MEMS device. Also related with reducing losses due to substrate coupling, a method for fabricating a floating FBAR structure has been disclosed in [27]. In that work, the thin film resonator includes a supporting means, a first electrode, a dielectric layer, and a second electrode. The FBAR supporting layer has posts and a supporting layer formed on the posts, yet comprising a three dimensional, floating construction. The supporting layer and posts are fabricated by means of surface micro-machining of a sacrificial layer. The overall structure is still supported on isolating substrate material such as silicon, glass or ceramic.

As it will be disclosed from the following description, in the present invention the FBAR is a three-dimensional, floating structure. As a difference to conventional two-dimensional FBAR or the floating structure presented in [27], the whole FBAR structure of the present invention is completely transferred to a supporting substrate, with no presence of sacrificial layer in the target substrate. Hence, no etching of the FBAR supporting substrate is needed. In one embodiment of the present invention, the FBAR is exclusively supported by two or more posts. This reduces the number of steps and time involved in the fabrication of the FBAR. At the same time, the supporting posts may be connecting points to a CMOS substrate, allowing for heterogeneous integration of FBAR-to-CMOS, being the FBAR placed above the integrated circuit. This means that die area may be reduced, compared to hybrid or even to FBAR-on-side-of-IC monolithic integration. This implies that no specific technology development is needed in order to provide with technologic compatibility to both FBAR and CMOS fabrication processes.

Broadly, it is an object of the present invention to provide a thin-film bulk acoustic wave resonator (FBAR) heterogeneously integrated with CMOS integrated-circuit in order to implement RF and sensor applications as well, and a method for manufacturing the thin-film resonator and the FBAR-to-CMOS integration.

It is another object of the present invention to provide a thin-film bulk acoustic wave resonator (FBAR) that may be fabricated by transferring of said FBAR on top of a supporting substrate, and a method for manufacturing the thin-film resonator.

It is still another object of the present invention to provide a thin-film bulk acoustic wave resonator (FBAR) that may be fabricated by transferring of said FBAR on top of an on-substrate CMOS integrated circuit, and a method for manufacturing the thin-film resonator and for design of the CMOS integrated-circuit.

It is still another object of the present invention to provide a thin-film bulk acoustic wave resonator (FBAR) having a three-dimensional, floating construction to minimize power loss due to acoustical and electric coupling to the substrate, and a method for manufacturing the thin-film resonator.

It is still another object of the present invention to reduce the fabrication time of a thin-film bulk acoustic wave resonator (FBAR) by transferring the same into a CMOS substrate with no need of etching of said substrate, and a method for manufacturing the thin-film resonator.

It is still another object of the present invention to provide fabrication compatibility for both thin-film bulk acoustic wave resonator (FBAR) and CMOS integrated circuit in order to integrate them into a compact RF or sensor application, and a method for achieving said compatibility.

It is still another object of the present invention to provide fabrication flexibility and versatility for the FBAR-to-CMOS interconnection technology, in order to integrate both thin-film bulk acoustic wave resonator (FBAR) and CMOS integrated circuit, and a method for achieving said flexibility and versatility.

It is a further object of the present invention to reduce die area for fabrication of FBAR-to-CMOS integrated RF and sensor applications as well, and a method for achieving said die area reduction.

These and other objects of the present invention will become apparent to those skilled in the art from the following detailed, description of the invention and the accompanying drawings.

### References

[1] N. H. Tea, V. Milanovic, C. A. Zincke, J. S. Suehle, M. Gaitan, M. E. Zaghloul, and J. Geist, "Hybrid postprocessing etching for CMOS-compatible MEMS", J. Microelectromech. Syst., vol. 6, pp. 363-372, Dec. 1997.
[2] L. Latorre, P. Nouet, Y. Bertrand, P. Hazard, and F. Pressecq, "Characterization and modeling of a CMOS-compatible MEMS technology," Sens. Actuators A, vol. 74/1-3, pp. 143-147, 1999.
[3] J. L. Lund, C. V. Jahnes, H. Deligianni, L. Paivikki Buchwalter, J. M. Cotte, P. Andricacos, D. E. Seeger, and J. H. Magerlein, "A low temperature Bi-CMOS compatible process for MEMS RF resonators and filters", Solid-State Sensor, Actuator and Microsystems Workshop, 2002, Hilton Head Island, South Carolina, June 2-6, 2002, pp. 38-41.
[4] K. M. Lakin and J. S. Wang, "Acoustic bulk wave composite resonators", Applied Physics Lett., vol. 38, pp. 125-127, Feb. 1981.
[5] R. Ruby, P. Bradley, J. Larson III, Y. Oshmyanski, and D. Figueredo, "Ultra-Miniature High-Q Filters and Duplexers Using FBAR Technology", in IEEE Intl. Solid-State Circuits Conf. Dig. of Tech. Papers, 2001, pp. 120-121.
[6] H. Campanella, J. Esteve, J. Montserrat, A. Uranga, G. Abadal, N. Barniol, and A. Romano-Rodriguez, "Localized and distributed mass detectors with high sensitivity based on thin-film bulk acoustic resonators", Applied Physics Lett., vol. 89, pp. 033507, Jun. 2006.
[7] H. Zhang and E. S. Kim, "Micromachined Acoustic Resonant Mass Sensor", IEEE J. Microelectromech. Syst., vol. 14, 4, pp. 699-706, Aug. 2005.
[8] M. Benetti, D. Cannatà, F. Di Pietrantonio, V. Foglietti, and E. Verona, "Microbalance chemical sensor based on thin-film bulk acoustic wave resonators", Appl. Phys. Lett., vol. 87, pp. 173504-1-3, Oct. 2005.
[9] B. P. Otis, and J. M. Rabaey, "A 300-µW 1.9-GHz CMOS oscillator utilizing micromachined Resonators", IEEE J. Solid-State Circuits, vol. 38, pp. 1271-1274, Jul. 2003.
[10] Y. H. Chee, A. M. Niknejad, and J. M. Rabaey, "An ultra-low-power injection locked transmitter for wireless sensor networks", IEEE J. Solid State Circuits, vol. 41, pp. 1740-1748, Aug. 2006.
[11] H. Zhang, J. Kim, W. Pang, H. Yu, and S. Kim, "5GHz lowphase-noise oscillator based FBAR with low TCF," 13th International Conference on Solid-State Sensors, Actuators and Microsystems Transducers 2005, pp. 1100-1101, Seoul, Korea, June 2005.
[12] W. C. Dunn, H. Ming Liaw, L. Ristic, and R. M. Roop, "Monolithic circuit with integrated bulk structure resonator", U.S. patent no. 5,260,596, Nov. 1993.
[13] K. Lee, Y. S. Eo, and S. Hyun, "Single-chip radio structure with piezoelectric crystal device integrated on monolithic integrated circuit and method of fabricating the same", U.S. patent no. 6,285,866, Sep. 2001.
[14] M.-A. Dubois, C. Billard, C. Muller, G. Parat, and P. Vincent, "Integration of high-Q BAW resonators and filters above IC", in IEEE Intl. Solid-State Circuits Conf. Dig. of Tech. Papers, 2005, pp. 392-393.
[15] J.F. Carpentier, A. Cathelin, C. Tilhac, P. Garcia, P. Persechini, P. Conti, P. Ancey, G. Bouche, G. Caruyer, D. Belot, C. Arnaud, C. Billard, G. Parat, J.B. David, P. Vincent, M.A. Dubois, and C. Enz, "A SiGe:C BiCMOS WCDMA zero-IF RF front-end using an above-IC BAW filter", in IEEE Intl. Solid-State Circuits Conf. Dig. of Tech. Papers, 2005, pp. 394-395.
[16] M. Aissi, E. Tournier, M. A. Dubois, C. Billard, H. Ziad, and R. Plana, "A 5 GHz above-IC FBAR low phase noise balanced oscillator", in Proc. of IEEE RFIC, 2006, vol. 1, pp. 25-28.
[17] D. Figueredo, R. C. Ruby, Y. Oshmyansky, and P. Bradley, "Thin film bulk acoustic resonator (FBAR) and inductor on a monolithic substrate and method of fabricating the same", U.S. patent no. 6,710,681, Mar. 2004.
[18] M.Furuhata, A.Yajima, K.Goto, H.Sato, T.Funasaka,S.Kawano, S.Fujii, T.Higuchi, M.Ueno, "Development of Monolithic CMOS-SAW Oscillator", in Proc. of IEEE Ultrason. Symp., 2005, Amsterdam, The Netherlands, Sept. 18-21, 2005, vol. 4, pp. 2194-2197.
[19] E. Forsen, G. Abadal, S. Ghatnekar-Nilsson, J. Teva, J. Verd, R. Sandberg, W. Svendsen, F. Perez-Murano, J. Esteve, E. Figueras, F. Campabadal, L. Montelius, N. Barniol, and A. Boisen, "Ultrasensitive mass sensor fully integrated with complementary metal-oxide-semiconductor circuitry", Appl. Phys. Lett., vol. 87, pp. 043507-1-3, July 2005.
[20] B. Ilic, H. G. Craighead, S. Krylov, W. Senaratne, C. Ober, and P. Neuzil, "Attogram detection using nanoelectromechanical oscillators", J. Appl. Phys., vol. 95, 7, pp.3694-3703, April 2004.
[21] D. Feld, P. Bradley, A. Barfknecht, and R. Ruby, "A Wafer Level Encapsulated FBAR Chip Molded into a 2.0 mm x 1.6 mm Plastic Package for Use as a PCS Full Band Tx Fitter", in Proc. IEEE Ultrason. Symp, Honolulu-Hawaii, USA, Oct. 5-8, 2003, vol. 1, pp.1798-1801.
[22] M. B. Cohn, and J.-H. Xu, "MEMS device with integral packaging", U.S. patent no. 6,872,902 B2, Mar. 2005.
[23] P. Bradley, J. D. Larson III, and R. C. Ruby, "Mounting film bulk acoustic resonators in microwave packages using flip-chip bonding technology", U.S. patent no. 6,550,664 B2, Abr. 2003.
[24] P. Bradley, "Packaging methodology for duplexers using FBARs", U.S. patent no. 6,838,956 B2, Jan. 2005.
[25] J. A. Philliber, and R. C. Ruby, "Method of fabricating a semiconductor device and an apparatus embodying the method", U.S. patent no. 6,794,958 B2, Sep. 2004.
[26] E. Bar-Sadeh, A. Talalyevsky, and E. Ginsburg, "Reduced substrate micro-electro-mechanical systems (MEMS) device and system for producing the same", U.S. patent no. 6,894,383 B2, May. 2005.
[27] E.-K. Kim, "Thin film resonator and method for manufacturing the same", U.S. patent no. 6,849,475 B2, Feb. 2005.

### DESCRIPTION OF THE INVENTION

### Brief description of the invention

A method for fabricating a thin-film bulk acoustic wave resonator (FBAR) and, at the same time, performing heterogeneous integration of said FBAR with complementary-metal-oxide-semiconductor (CMOS) integrated circuit (IC). Integration of FBAR to CMOS-IC is performed with independence of FBAR or IC fabrication technologies. Wafer-level or chip-level integration is performed under decision of the designer, being possible to implement wafer-to-wafer, wafer-to-chip or chip-to-chip transfer processes. In the preferred embodiment of this invention, wafer-level-transfer is carried-out, being said FBAR suspended above the IC substrate and connected to the IC by at least two electrical-connecting points. Said connecting points provide the FBAR-to-IC integration and may be implemented as soldering bumps, thru-hole or via-hole-fabricated supporting posts, or electro-plating deposition. This invention is understood to not be limited to FBAR devices, and its principles may be applied to other suitable MEMS devices.

### Brief description of the drawings

**FIG. 1A** is top view showing the integrated FBAR-to-CMOS ensemble according to one preferred embodiment of this invention.
**FIG. 1B** is cross-sectional cutaway view of the device of **FIG.1A** cut along line A-A'.
**FIGS. 2A** to **2D** are cross-sectional views illustrating a method for manufacturing a thin-film bulk acoustic resonator according to one embodiment of this invention.
**FIG. 3** is cross-sectional view showing a CMOS process according to one embodiment of this invention.
**FIGS. 4A** to **4D** are cross-sectional view of the heterogeneous integration process of FBAR to CMOS substrate, according to one embodiment of this invention.

### Detailed description of the invention

Although the present invention is not limited in this regard, the term "MEMS device" as used herein may be understood to include, inter alia, any suitable micro-electromechanical system device, for example, a thin-film bulk acoustic resonator (FBAR), an FBAR filter, and FBAR RF filter, a RF switch, a varactor, a tunable capacitor, or any other MEMS device where it may be relevant to apply the principles of the present invention. Although an exemplary embodiment of the present invention may include a single FBAR device, it is presented herein only as an example of applying the principles of the present invention to a MEMS device; the present invention is not limited in this regard, and its principles may be applied to other suitable MEMS devices.

Hereinafter, preferred embodiments of the present invention will be described in more detail with reference to the accompanying drawings, but it is understood that the present invention should not be limited to the following embodiments.

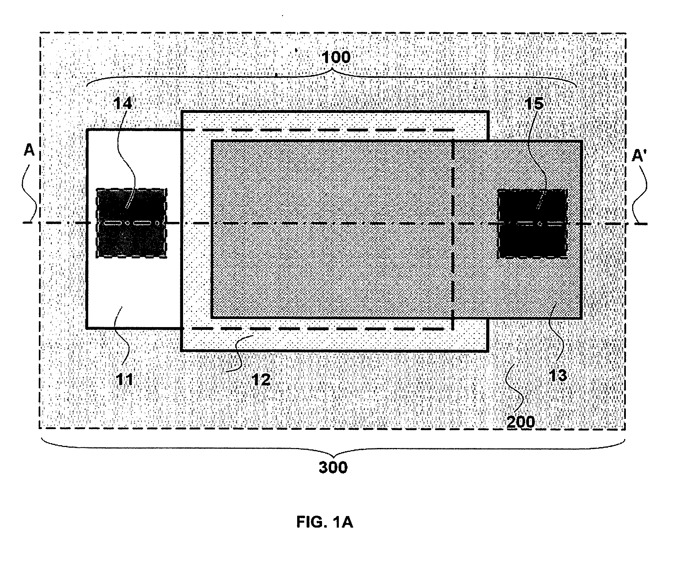

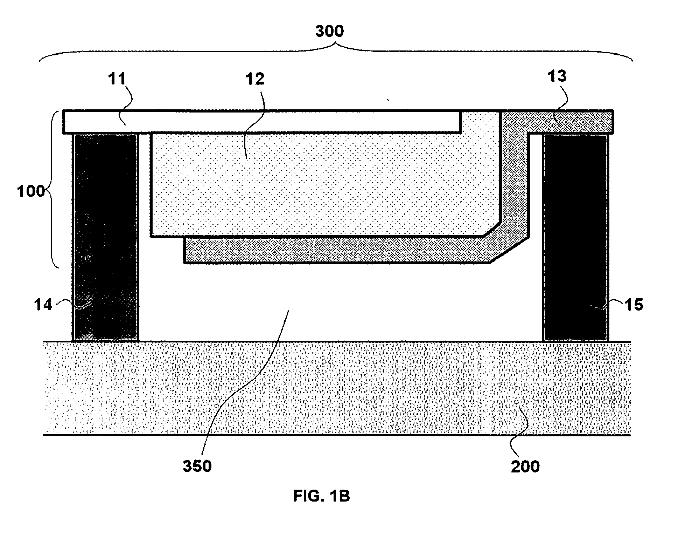

In one embodiment of the present invention, an FBAR is placed on and connected to a CMOS substrate, thus configuring a floating structure on the substrate. Also in one embodiment of the present invention, the CMOS substrate may carry integrated circuitry, although this is not strictly necessary, being enough a CMOS substrate carrying connecting interfaces to the FBAR. **FIG. 1A** and **FIG. 1B** are schematics illustrating top and cross-sectional views of the integrated FBAR-to-CMOS **300,** where FBAR 100 is placed on CMOS substrate **200.** In this way, the only supporting means, making the FBAR **100** a three-dimensional, floating structure, are the posts **14** and **15.** At the same time, posts **14** and **15** serve as connecting points, providing electrical contact between FBAR **100** and CMOS substrate **200.** It will be appreciated by persons skilled in the art that, in embodiments of the present invention, supporting substrate **200** may be a CMOS substrate carrying passive devices, dummy interconnections, test structures, integrated circuitry, or combinations of one or more of these. Also, it will be appreciated to those skilled in the art that the present invention is not limited to CMOS technologies, being possible to apply the present invention to other integrated circuit technologies. Thus, an exemplary embodiment of the present invention includes CMOS technology as substrate **200** for providing support to FBAR **100.** On the other hand, it will become apparent to those skilled in the art that, since the floating configuration of FBAR **100** provides it with acoustical and mechanical isolation to substrate **200,** the same principles may be applied to other micro-machined movable structures, for example, MEMS devices including FBAR filters, FBAR RF filters, RF switches, varactors, tunable capacitors, or any other suitable MEMS device. Referring to **FIG. 1A** and **FIG. 1B****,** FBAR 100 is conformed by metal electrodes **11** and **13,** and acoustic material thin-film **12.** In **FIG. 1** **B** the air interface **350** between FBAR **100** and substrate **200** provides acoustical and mechanical isolation between FBAR and substrate, in order to guarantee a high quality factor. This air interface is the result of one of the fabrication processes described following.

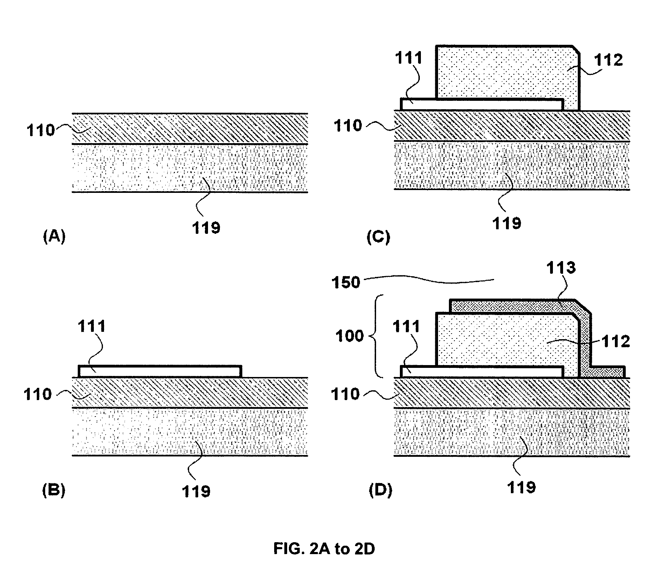

Referring to **FIGs. 2A** to **2D**, schematic description of the fabrication process of FBAR 100 is given, according to one embodiment of the present invention. In **FIG. 2A** a sacrificial layer **110** is deposited on top of the silicon substrate **119.** Said sacrificial layer **110** will be released when FBAR **100** and substrate **200** are to be integrated. Other dielectric layers having similar properties to PSG may be implemented in other embodiments of the present invention. The next step of the fabrication process of FBAR **100** is illustrated in FIG. **2B**, where a metal electrode **111** is deposited on top of sacrificial layer **110.** In one embodiment of the present invention, the material composing the metal electrode may be selected from the group of platinum, molybdenum, aluminum, gold, tungsten, tantalum, or any other having good electrical conductivity properties. At the same time, this material is to provide crystallographic compatibility with the acoustical material to be used for implementation of the acoustic thin-film layer **112** in **FIG.2C** and **2D**. For the purpose of obtaining good crystallographic orientation and piezoelectric properties, acoustic material is deposited on top of the first metal electrode **111,** which is made of one of the materials yet mentioned, or others with similar properties. In one embodiment of the present invention, the thin-film acoustic layer is deposited by means of RF sputtering, with no prejudice of other deposition or growing techniques, for example, epitaxial, or plasma-assisted deposition. In the same way, compatibility issues with CMOS technologies are not relevant to choose the thin-film acoustic layer, since FBAR **100** and substrate **200** are independent processes, being integrated just at the final step of the whole manufacturing process. In one embodiment of the present invention, the material composing the thin-film acoustic layer may be selected from the group of aluminum nitride (AIN), zinc-oxide (ZnO), lead zirconate titanate (PZT), lead tantalum zirconate titanate (PLZT), or any other material exhibiting good piezoelectric properties. In **FIG. 2D**, it is illustrated the last step of the FBAR 100 fabrication process, before integration to CMOS substrate, which is deposition of the second metal electrode **113.** In one embodiment of the present invention, the material composing the metal electrode may be selected from the group of platinum, molybdenum, aluminum, gold, tungsten, tantalum, or any other having good electrical conductivity properties. Metal electrode **113** is deposited on top of the thin-film acoustical layer **112,** and may be manufactured by the same processes carried-out to fabricate the first electrode. In the preferred embodiment of the present invention, and as a difference to conventional FBAR devices, the FBAR **100** is provided with no air-interface or reflecting-mirror stack underneath the first metal electrode **111.** Since air interface **350** will be provided in successive steps of the integration process, no additional steps are required for the FBAR 100 manufacturing process.

**FIG. 3** illustrates schematic of the cross-sectional view of an exemplary integrated-circuit process **211** fabricated on a carrying substrate **210.** In one embodiment of the present invention, the integrated-circuit process **211** may be, but not restricted to, CMOS, being possible alternative implementations in bipolar, BiCMOS, SOI, or other integrated-circuit technologies. In the preferred embodiment of this invention the integrated-circuit process may include a protective layer **212** on top of the remaining layers of the process. At its time, said protective layer **212** is provided with at least two opening windows **213** and **214** just above the top electrical conducting layer, or above of any other electrical conducting layer provided by the integrated-circuit technology. The opening windows **213** and **214** will serve as landing pads **215** and **216** to FBAR-to-CMOS interconnection. According to the present invention, alternative configurations of the integrated-process may not include protective layer or opening windows on the latter. In these cases, additional post-processing steps will be required in the integrated-circuit, in order to provide opening windows and protective layer on top of the integrated-circuit layers. Among these steps it may be implemented, inter alia, protective layer deposition and photolithography. Additional steps conducting to provide protective layer and opening windows on top of the integrated-circuit process will become apparent to those skilled in the art of integrated-circuit manufacturing.

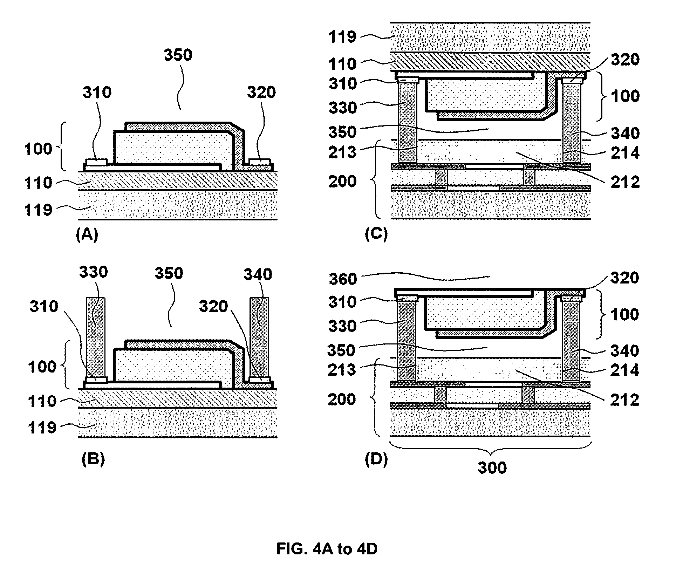

Referring to **FIGs. 4A** to **4D**, schematic of the FBAR-to-CMOS heterogeneous integration process is illustrated for one embodiment of the present invention. In **FIG. 4A****,** deposition and etching of an alloy or stack of metals suitable for soldering or electro-platting is carried-out, thus defining landing pads **310** and **320.** This step is required if metal electrodes **111** and **113** of FBAR **100** are not made of materials suitable to adherence for soldering or electro-platting purposes. In one embodiment of the present invention, the materials composing the landing pads **310** and **320** may be selected from the group of nickel, gold, titanium, among others. **FIG.4B** illustrates how connecting posts **330** and **340** are placed on top of landing pads **310** and **320.** Connecting posts **330** and **340** will provide support and electrical connection to FBAR **100,** giving to it the suspended configuration described in the preferred embodiment of the preferred invention. The techniques and methods required to implement posts **330** and **340** are diverse and include, inter alia, mask-driven deposition of soldering paste, metal deposition, and electro-platting assisted deposition. FIG. **4C** is schematic describing the interconnection between FBAR and CMOS substrates. First, substrate **119** carrying FBAR **100** is vertically swapped and aligned to integrated-circuit substrate **200.** This is done to provide alignment between connecting post **330** and opening window **213,** and between connecting post **340** and opening window **214.** The swapping and alignment procedures may be implemented by manual or automatic means. It is to be noticed that the whole FBAR structure is swapped during this step, being now the former top electrode **113** the one to be closest to the integrated circuit. At its time, the FBAR-carrying substrate **119** is now the most top layer of the suspending structure. It is also to be noticed that, due to bigger size of connecting posts **330** and **340,** compared to thickness of FBAR **100,** an air interface is now provided between FBAR and substrate **200.** Mechanical interconnection of connecting posts **330** and **340** to pads **215** and **216** depends on the integration process. For example, in one embodiment of the present invention, connecting posts **330** and **340** are soldering bumps that are heated and soldered to integrated-circuit pads **215** and **216,** in one side, and to FBAR pads **310** and **320,** in the other side. In other embodiments of the present invention, soldering may be replaced by electro-platting or deposition techniques, in order to achieve the interconnection described in **FIG.4C****.** Referring to **FIG.4D****,** final release of FBAR is performed by wet etching of sacrificial layer **110,** thus achieving complete integration between the FBAR **100** and the substrate **200.** Since sacrificial layer **110** isolates FBAR **100** of substrate **119,** the latter is also released when complete etching is achieved, separating both FBAR and substrate. At this point substrate **119** is of no interest and is discarded for manufacturing purposes. In one embodiment of the present invention, wet etching is performed by means of fluorhydric acid (HF). At its time, FBAR **100** is fully released and connected to substrate **200,** which may be an only supporting substrate or may carry passive or active devices. In the preferred embodiment of the present invention, the substrate carries integrated-circuit devices, thus providing fully-integrated FBAR-to-CMOS application system **300.** It is to be noticed that after the releasing process of sacrificial layer **110,** FBAR **100** exhibits two air interfaces, **350** and **360,** respectively. Hence, FBAR **100** has mechanical freedom to vibrate since no acoustical coupling exists between it and any substrate. This fact is necessary condition to guarantee good quality factors.

Various modifications to the present invention will become apparent to those skilled in the art from the foregoing description and accompanying drawings.

### DETAILED DESCRIPTION OF THE PREFERRED EMBODIMENT

Referring to **FIG. 2A to 2D**, FBAR configuration may be as follows: a 1µm-thick phosphor silicate glass (PSG) layer **110** is deposited on a 550µm-thick silicon wafer. Next, a 180nm Cr/Pt (30nm of Cr for adhering purposes) is deposited and the first electrode **111** defined by lift-off. Afterwards, acoustic layer **112** is composed of a 1µm-thick aluminum nitride (AIN) layer, being the resonator's shape defined by wet-etching. Finally, the second electrode **113** is made according to the same configuration of first electrode.

Referring to **FIG. 3**, CMOS substrate **200** may be fabricated according to the typical structure of a CMOS technology, i.e. a top metal layer **217** for interconnecting covered by a dielectric protective layer **212.** This layer may be, for example, a 500nm-thick PECVD silicon oxide layer, with photolithography-defined openings **215** and **216** for pad connection. Metal layer **217** may be manufactured by one or more of the following configurations: platinum over chromium, aluminum over chromium, aluminum over titanium, among others. Possible metal configurations are mainly determined by the etchant solution implemented for subsequent FBAR-to-CMOS integration.

Referring to **FIG. 4A** to **4D**, FBAR-to-CMOS integration may be performed as follows: first, landing pads **310** and **320** may be selected from the group of nickel (Ni), gold (Au), titanium (Ti), or combination of two or all of them. For example, thicknesses for Ni, Au and Ti may be 30nm, 20nm and 50nm, respectively. If the top metal of CMOS technology does not provide with adhesive metals for interconnection with soldering bumps, similar procedure should also be practiced on top metal **217** of CMOS substrate. Next step is to place contacting posts **330** and **340** on top of landing pads **310** and **320.** These posts may be soldering bumps, made of an alloy of nickel and lead (Pb). In this case, soldering paste is applied to wafer by means of masking-aided appliance and alignment system. Once deposited the paste, manual or automatic pick-and-place system may be used to position, align and soft contact FBAR and CMOS wafers in proper location. Once both wafers are positioned in such a way that soldering paste contacts both FBAR and corresponding CMOS pads, the ensemble is introduced in oven or heating machine, in order the soldering paste to liquefy and subsequent cooling to solder both endings of landing pads, allowing for hard interconnection between both FBAR and CMOS substrates. Finally, PSG layer **110** is attacked by means of HF-etching, releasing silicon substrate layer **119.** At this point, FBAR exhibits full acoustic isolation by means of two air interfaces up and down of electrodes and, at the same time, full interconnection with CMOS substrate.

Various modifications to the present invention will become apparent to those skilled in the art from the foregoing description and accompanying drawings.

## Claims

1. Thin-film bulk acoustic wave resonator (FBAR) comprising:
- a first metal electrode;
- an acoustic layer;
- a second metal electrode;
- a carrier substrate;
- two or more supporting posts, said supporting posts connecting said first metal electrode and said second metal electrode to said carrier substrate;
said first metal electrode, said acoustic layer and said second metal electrode arranged in a three-dimensional, floating structure, being said structure supported and interconnected to said carrier substrate by means of said supporting posts;
said first metal electrode interfacing in the vertical direction one of its surfaces with said acoustic layer and the second one with the air on top of said first metal electrode;
said acoustic layer interfacing in the vertical direction one of its surfaces with said first metal electrode and the second one with said second metal electrode;
said second metal electrode interfacing in the vertical direction one of its surfaces with said acoustic layer and the second one with the air cavity formed in between said first metal electrode and said carrier substrate.

2. The apparatus recited in claim **1** wherein said supporting posts are made of conducting materials to provide electrical contact for said FBAR.

3. The apparatus recited in claim **1** wherein at least one of said supporting posts is placed and electrically-connected to said first electrode of FBAR.

4. The apparatus recited in claim **1** wherein at least another one of said supporting posts is placed and electrically-connected to said second electrode of FBAR.

5. The apparatus recited in claim **1** wherein there is no electrical connection between said first electrode and said second electrode, or between corresponding said supporting posts.

6. The apparatus recited in claim **1** wherein said supporting posts are connected to said FBAR, by one side, and to said carrier substrate, by the another side.

7. The apparatus recited in claim **1** wherein said carrier substrate may be an integrated-circuit technology substrate including circuit elements, an only-carrying substrate, or combination of the same.

8. The apparatus recited in claim **1** wherein said carrier integrated-circuit technology substrate, may be fabricated according to CMOS, bipolar, BiCMOS, GaAs or similar integrated-circuit technology.

9. An apparatus comprising:
a first device chip including a thin-film bulk acoustic wave resonator (FBAR);
a second device chip including circuit elements fabricated on a substrate, said second device chip having, at least, a first contact point and a second point to said FBAR;
supporting posts;
said first device chip including a number of FBAR and said second device chip including circuit elements interconnected by said supporting posts.

10. A method of fabricating an apparatus, the method comprising:
fabricating a first device chip including a thin-film bulk acoustic wave resonator (FBAR), sacrificial layer and substrate, said FBAR having a fist metal electrode, an acoustic layer, a second metal layer and, at least, first contact point and second contact point;
fabricating supporting posts, said supporting posts being placed on said first and second contact points of said FBAR;
placing said first device chip including a FBAR on top of a second device chip including circuit elements fabricated on a substrate whereby said first and second contacts of FBAR make electrical contact with said first and second contacts of said second device chip including circuit elements fabricated on a substrate;
processing said first device chip including a FBAR to release said FBAR from its substrate.

11. A method of fabricating an apparatus, the method comprising:
fabricating a first device chip including a thin-film bulk acoustic wave resonator (FBAR), sacrificial layer and substrate, said FBAR having a fist metal electrode, an acoustic layer, a second metal layer and, at least, first contact point and second contact point;
fabricating supporting posts, said supporting posts being placed on said first and second contact points of said FBAR;
placing a second device chip including circuit elements fabricated on a substrate on top of said first device chip including a FBAR whereby said first and second contacts of FBAR make electrical contact with said first and second contacts of said second device chip including circuit elements fabricated on a substrate;
processing said first device chip including a FBAR to release said FBAR from its substrate.

12. The method for fabricating a thin film acoustic resonator as recited in claim **10** and claim **11** wherein a sacrificial layer is deposited on the top surface of a silicon substrate having top and bottom surfaces.

13. The method for fabricating a thin film acoustic resonator as recited in claim **10** and claim **11** wherein a first metallic layer is deposited-on and lifted-off the top surface of said sacrificial layer thus comprising a first metal electrode.

14. The method for fabricating a thin film acoustic resonator as recited in claim **10** and claim **11** wherein an acoustic, piezoelectric layer is deposited and etched on the top surface of said first electrode.

15. The method for fabricating a thin film acoustic resonator as recited in claim **10** and claim **11** wherein a second metallic layer is deposited-on and lifted-off the top surface of said acoustic, piezoelectric layer thus comprising a second metal electrode.

16. The method recited in claim **10** and claim **11** further comprising adhesive-metal layer deposition and etching on top of said first and second electrodes of said FBAR in order to provide landing pads to said FBAR.

17. The method recited in claim **10** and claim **11** further comprising fabrication of supporting posts on top of said landing pads of said FBAR.

18. The method recited in claim **10** and claim **11** further comprising vertical turning of said first device chip including said FBAR in order to connect said FBAR to said second device chip including circuit elements.

19. The method recited in claim **10** and claim **11** further comprising alignment of said first device chip including said FBAR to said second device chip including circuit elements in order to interconnect both device chips.

20. The method recited in claim **10** and claim **11** further comprising soft-contacting, once aligned, of said first device chip including said FBAR to said second device chip including circuit elements in order to interconnect both device chips.

21. The method recited in claim **10** and claim **11** further comprising hard-contacting, once soft-connected, of said first device chip including said FBAR to said second device chip including circuit elements in order to complete interconnection of both device chips.

22. The method recited in claim **10** and claim **11** further comprising etching of said sacrificial layer of said first device chip including said FBAR in order to release silicon substrate of said first device chip including said FBAR.

23. The method recited in claim **22** wherein said etching of said sacrificial layer of said first device chip including said FBAR provides full acoustic and mechanical releasing of said FBAR, being said FBAR located on top of said second device chip including circuit elements.

24. The method recited in claim **22** wherein said etching of said sacrificial layer of said first device chip including said FBAR provides full integration and interconnection of said FBAR with said second device chip including circuit elements.

25. The method recited in claim **10** and claim **11** wherein said method may be implemented at the chip-level or at the wafer-level, as well.

26. Radio-frequency (RF) system or device according to claim **1** and claim **9,** comprising ensemble of one or more thin-film bulk acoustic wave resonator (FBAR) and integrated-circuit in which at least one of the resonators is connected to the integrated-circuit in order to provide radio-frequency functionality such as band selection filter, pre-selection filter, band-rejection filter, duplexer, oscillator, mixer, tuned low-noise amplifier, power-amplifier, or similar RF system in which said FBAR is fundamental technology to provide the system with proper functionality.

27. Sensing system or device according to claim **1** and claim **9,** comprising ensemble of one or more thin-film bulk acoustic wave resonator (FBAR) and integrated-circuit in which at least one of the resonators is connected to the integrated-circuit in order to provide read-out or processing functionality to said sensing system such as pull-in amplifier, read-out amplifier, zero-crossing detector, or similar sensing system in which said FBAR is fundamental technology to provide the system with proper functionality.
